# EUROPEAN PATENT APPLICATION

(11) **EP 4 199 397 A1**
(43) Date of publication of application: **21.06.2023**
(21) Application number: 21871102.6
(22) Date of filing: 06.08.2021
(51) Int. Cl.: H04L 1/00

(54) **DATA SENDING METHOD AND TERMINAL, DATA RECEIVING METHOD AND TERMINAL, AND SYSTEM, DEVICE AND READABLE STORAGE MEDIUM**

(30) Priority: 27.09.2020 CN 202011032447
(71) Applicant: ZTE Corporation, Shenzhen, Guangdong 518057 (CN)
(72) Inventor: TAO, Kai, Shenzhen, Guangdong 518057 (CN)
(74) Representative: Zoli, Filippo
(86) International application number: PCT/CN2021/111289
(87) International publication number: WO 2022/062725

(57) **Abstract**

A data sending method and terminal, a data receiving method and terminal, and a system, a device and a readable storage medium. The data sending method comprises: acquiring source data to be sent; performing probabilistic shaping processing on the source data, and obtaining probabilistic mapping data, wherein the probabilistic mapping data comprises shaped data and unshaped data; performing pre-interleaving processing on the probabilistic mapping data, and obtaining interleaved data; performing forward error correction coding processing on the interleaved data to obtain check data, and performing post-interleaving processing on the interleaved data and coded data to obtain data to be modulated; and modulating the data to be modulated, and obtaining modulated symbol data.

## Description

### CROSS-REFERENCE TO RELATED APPLICATION

This application is filed on the basis of Chinese patent application No. 202011032447.9 filed September 27, 2020, and claims priority of the Chinese patent application, the entire contents of which are incorporated herein by reference.

### TECHNICAL FIELD

The present disclosure relates to the field of communication, in particular to a data sending/receiving method and terminal, an electronic device, a data communication system and a readable storage medium.

### BACKGROUND

In a communication transmission system, input signals are subjected to probabilistic shaping to generate shaping gain, thereby reducing the average power of the signals and increasing the transmission distance of the system.

In some cases, signals not subjected to probabilistic shaping and signals subjected to probabilistic shaping and mapping are interleaved by an interleaver. However, in the process of signal interleaving, the signal layout is prone to crosstalk, so that the signals cannot be shaped to produce shaping gain.

### SUMMARY

Embodiments of the present disclosure provide a data sending/receiving method and terminal, a system, a device, and a readable storage medium.

In accordance with a first aspect of the present disclosure, an embodiment provides a data sending method. The method includes: acquiring first source data to be sent; performing probabilistic shaping on part of the first source data to obtain first shaped data and first unshaped data; pre-interleaving the first shaped data to obtain first pre-interleaved data, and pre-interleaving the first unshaped data to obtain second pre-interleaved data; performing forward error correction coding on the first pre-interleaved data and the second pre-interleaved data to obtain first check data; post-interleaving the first pre-interleaved data to obtain first post-interleaved data, and post-interleaving the second pre-interleaved data and the first check data to obtain second post-interleaved data; and modulating the first post-interleaved data and the second post-interleaved data to obtain modulated symbol data.

In accordance with a second aspect of the present disclosure, an embodiment provides a data receiving method. The method includes: acquiring modulated symbol data; demapping the modulated symbol data to obtain first demapped data, and pre-deinterleaving the first demapped data to obtain first deinterleaved mapped data; performing forward error correction decoding on the first deinterleaved mapped data to obtain first decoded data; post-deinterleaving the first decoded data to obtain first shaped data, first unshaped data and first check data; deshaping the first shaped data, and integrating the data obtained by deshaping with the first unshaped data and the first check data to obtain first source data.

In accordance with a third aspect of the present disclosure, an embodiment provides a data sending terminal. The data sending terminal includes: a first source data module, configured to generate first source data; a first probabilistic shaper, configured to perform probabilistic shaping on part of the first source data to obtain first shaped data and first unshaped data; a first pre-interleaver, configured to pre-interleave the first shaped data to obtain first pre-interleaved data, and pre-interleave the first unshaped data to obtain second pre-interleaved data; a first forward error correction encoder, configured to perform forward error correction coding on the first pre-interleaved data and the second pre-interleaved data to obtain first check data; a first post-interleaver, configured to post-interleave the first pre-interleaved data to obtain first post-interleaved data, and post-interleave the second pre-interleaved data and the first check data to obtain second post-interleaved data; and a symbol modulator, configured to modulate the first post-interleaved data and the second post-interleaved data to obtain modulated symbol data.

In accordance with a fourth aspect of the present disclosure, an embodiment provides a data receiving terminal. The data receiving terminal includes: a symbol demodulator, configured to demap modulated symbol data to obtain first demapped data; a first pre-deinterleaver, configured to pre-deinterleave the first demapped data to obtain first deinterleaved mapped data; a first forward error correction decoder, configured to perform forward error correction decoding on the first deinterleaved mapped data to obtain first decoded data; a first post-deinterleaver, configured to post-deinterleave the first decoded data to obtain first shaped data, first unshaped data and first check data; a first probabilistic deshaper, configured to deshape the first shaped data and transmit generated data to a first data receiver; and the first data receiver, configured to integrate the data from the first probabilistic deshaper with the first unshaped data and the first check data to obtain first source data.

In accordance with a fifth aspect of the present disclosure, an embodiment provides a data communication system. The system includes: the data sending terminal of the third aspect of the present disclosure and/or the data receiving terminal of the fourth aspect of the present disclosure.

In accordance with a sixth aspect of the present disclosure, an embodiment provides an electronic device, which includes: a memory storing a computer program; and a processor configured to execute the computer program stored in the memory to implement: the data sending method of the first aspect of the present disclosure and/or the data receiving method of the second aspect of the present disclosure.

In accordance with a seventh aspect of the present disclosure, an embodiment provides a computer-readable storage medium storing a computer-executable instruction which, when executed by a processor, causes the processor to implement the data sending method of the first aspect of the present disclosure and/or the data receiving method of the second aspect of the present disclosure.

Other features and advantages of the present disclosure will be set forth in the following specification, and partly become apparent from the specification, or are understood by implementing the present disclosure. The objectives and other advantages of the present disclosure can be realized and obtained by the particularly specified structure in the specification, claims, and accompanying drawings.

### BRIEF DESCRIPTION OF DRAWINGS

Fig. 1 is a flowchart of a data sending method according to an embodiment of the present disclosure;
Fig. 2A is a constellation point probability distribution diagram of a standard 16 QAM constellation according to an embodiment of the present disclosure;
Fig. 2B is a constellation point probability distribution diagram of a 16 QAM constellation graph after probabilistic shaping according to an embodiment of the present disclosure;
Fig. 3 is a comparison diagram of rate adaptability and performance of a different coding modulation scheme according to an embodiment of the present disclosure;
Fig. 4 is a sub-flowchart of a data sending method according to another embodiment of the present disclosure;
Fig. 5 is a sub-flowchart of a data sending method according to yet another embodiment of the present disclosure;
Fig. 6 is a sub-flowchart of a data sending method according to yet another embodiment of the present disclosure;
Fig. 7 is a sub-flowchart of a data sending method according to yet another embodiment of the present disclosure;
Fig. 8 is a schematic diagram of a conventional data output mode of a data sending method;
Fig. 9 is a schematic data output diagram of a data sending method according to an embodiment of the present disclosure;
Fig. 10 is a flowchart of a data sending method according to an embodiment of the present disclosure;
Fig. 11 is a flowchart of a data sending method according to another embodiment of the present disclosure;
Fig. 12 is a flowchart of a data sending method according to yet another embodiment of the present disclosure;
Fig. 13 is a flowchart of a data sending method according to yet another embodiment of the present disclosure;
Fig. 14 is a schematic frame diagram of a data sending terminal according to an embodiment of the present disclosure;
Fig. 15 is a schematic frame diagram of a data sending terminal according to another embodiment of the present disclosure;
Fig. 16 is a schematic frame diagram of a data receiving terminal according to an embodiment of the present disclosure; and
Fig. 17 is a schematic frame diagram of a data receiving terminal according to another embodiment of the present disclosure.

Reference numerals: 110. first source data module; 120. first probabilistic shaper; 121. first probabilistic shaping distribution matcher; 122. first data cache; 130. first pre-interleaver; 140. first forward error correction encoder; 150. first post-interleaver; 160. symbol modulator; 170. hybrid interleaver; 210. second source data module; 220. second probabilistic shaper; 221. second probabilistic shaping distribution matcher; 222. second data cache; 230. second pre-interleaver; 240. second forward error correction encoder; 250. second post-interleaver; 310. first data receiver; 320. first probabilistic deshaper; 321. first probabilistic shaping distribution dematcher; 322. third data memory; 330. first post-deinterleaver; 340. first forward error correction decoder; 350. first pre-deinterleaver; 360. symbol demodulator; 370. hybrid deinterleaver; 410. second data receiver; 420. second probabilistic deshaper; 421. second probabilistic shaping distribution dematcher; 422. fourth data memory; 430. second post-deinterleaver; 440. second forward error correction decoder; 450. second pre-deinterleaver.

### DETAILED DESCRIPTION

Objectives, technical schemes and advantages of the present disclosure will be clearer from a detailed description of embodiments of the present disclosure in conjunction with the drawings. It should be understood that the specific embodiments described here are only used to illustrate the present disclosure, and are not intended to limit the present disclosure. The embodiments in the present disclosure and the features in the embodiments may be arbitrarily combined with each other if not in collision.

It is to be noted, although functional modules have been divided in the schematic diagrams of apparatuses and logical orders have been shown in the flowcharts, in some cases, the modules may be divided in a different manner, or the steps shown or described may be executed in an order different from the orders as shown in the flowcharts. The terms such as "first", "second" and the like in the description, the claims, and the accompanying drawings are used to distinguish similar objects, and are not necessarily used to describe a specific sequence or a precedence order.

In some cases, signals are coded and modulated to reduce the transmission power consumption per unit information, thereby reducing information transmission costs of the communication system.

Probabilistic Constellation Shaping (PCS) can reduce the occurrence probabilities in sequence from inside to outside by adjusting occurrence probabilities of bits corresponding to amplitudes of constellation points, while ensuring that the relative positions of all constellation points in a Quadrature Amplitude Modulation (QAM) constellation remain unchanged, thereby reducing the average power.

However, after signals are subjected to probabilistic shaping and Forward Error Correction (FEC) coding, in the process of signal interleaving, the signal layout is prone to crosstalk, so that corresponding constellation mapping and modulation cannot be performed on signal data.

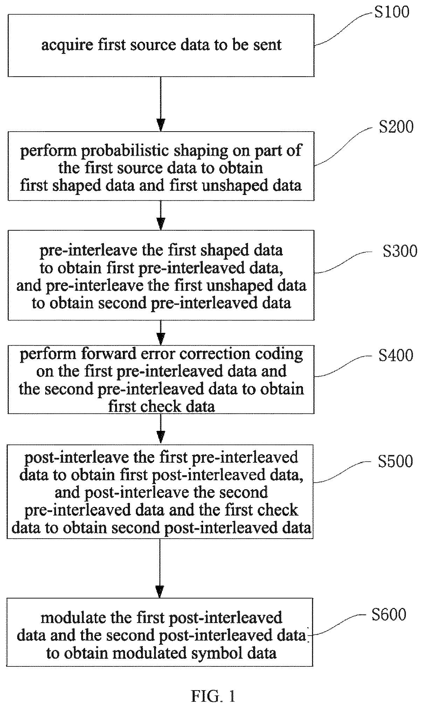

In a first aspect, referring to Fig. 1, an embodiment of the present disclosure provides a data sending method including following steps. At S100, first source data to be sent is acquired. At S200, probabilistic shaping is performed on part of the first source data to obtain first shaped data and first unshaped data. At S300, the first shaped data is pre-interleaved to obtain first pre-interleaved data, and the first unshaped data is pre-interleaved to obtain second pre-interleaved data. At S400, forward error correction coding is performed on the first pre-interleaved data and the second pre-interleaved data to obtain first check data. At; S500, the first pre-interleaved data is post-interleaved to obtain first post-interleaved data, and both the second pre-interleaved data and the first check data are post-interleaved to obtain second post-interleaved data. At S600, both the first post-interleaved data and the second post-interleaved data is modulated to obtain modulated symbol data.

The first shaped data and the first unshaped data are pre-interleaved respectively to generate corresponding first pre-interleaved data and second pre-interleaved data, so that data subjected to probabilistic shaping is prevented from interleaving with data not subjected to probabilistic shaping to cause data interleaving confusion, which makes it impossible to modulate and map the corresponding interleaved data correctly. It can be understood that by dividing data and interleaving different types of data separately, the situation of interleaving of different types of data in the interleaved data is avoided, thus ensuring that modulated symbol data conforming to preset parameters can be obtained by modulating the interleaved data.

The shaped data and the unshaped data are interleaved separately to ensure that the data are interleaved and laid out in a preset mode, thus avoiding the problem that shaping gain cannot be obtained by shaping the signals due to data interleaving.

In addition, the first pre-interleaved data and the second pre-interleaved data are subjected to forward error correction coding to obtain first check data, and the second pre-interleaved data and the first check data are post-interleaved to obtain corresponding second post-interleaved data, so that the check data is able to be incorporated into data to be modulated. Therefore, redundant codes with characteristics of signals are incorporated into the sent data, so that data errors caused by data transmission can be corrected.

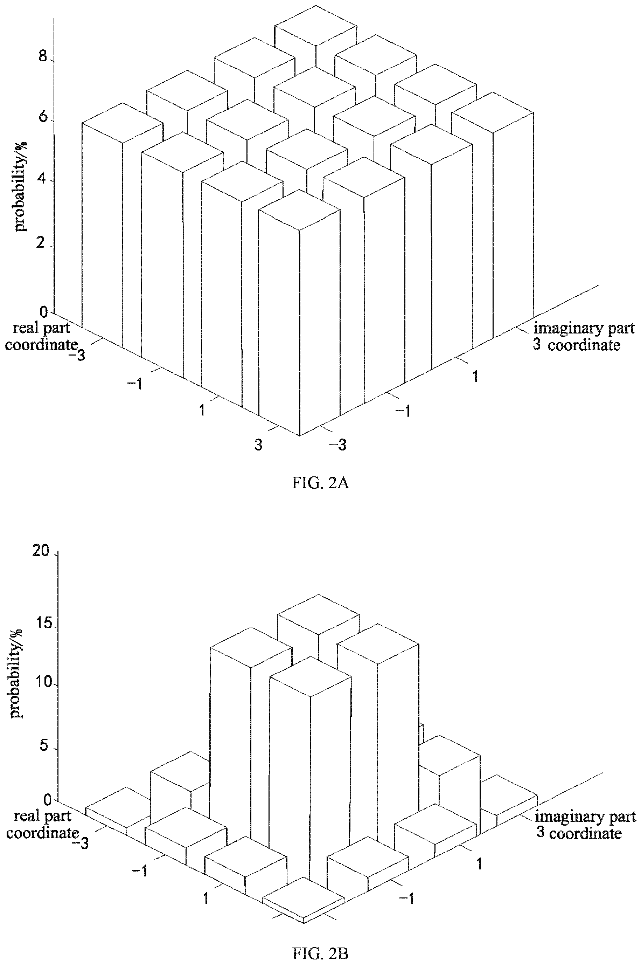

Referring to Fig. 2A and Fig. 2B, Fig. 2A is a constellation point probability distribution diagram of a standard 16 QAM constellation graph, and Fig. 2B is a constellation point probability distribution diagram of a 16 QAM constellation graph after probabilistic shaping, where the plane coordinate represents position, and the vertical coordinate represents constellation point probability.

It can be seen from the comparison of the figures that after occurrence probabilities of bits corresponding to amplitudes of constellation points is adjusted, the occurrence probabilities are reduced in sequence from inside to outside while ensuring that the relative positions of all the constellation points in the QAM constellation remain unchanged, thus reducing the average power.

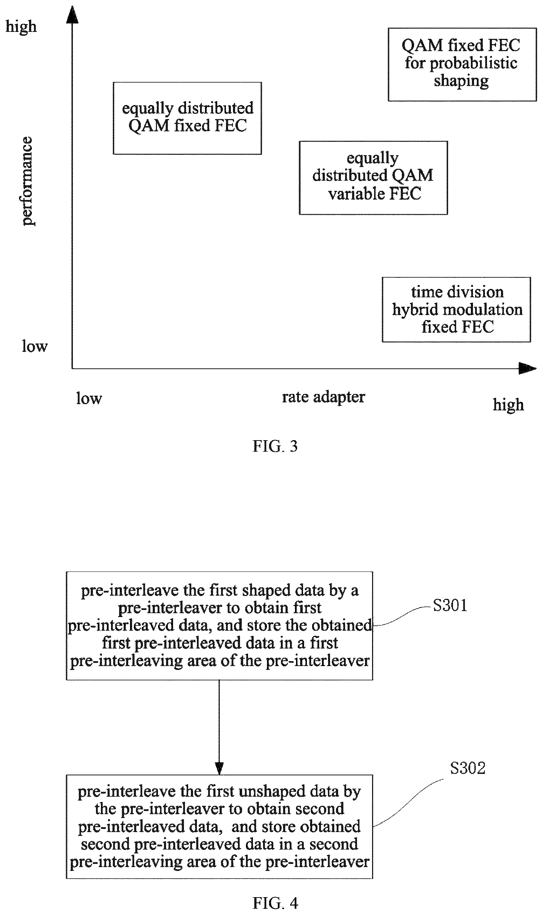

Referring to Fig. 3, QAM represents constellation mapping, and FEC represents forward error correction. In the figure, the horizontal coordinate represents rate adaptability, and the vertical coordinate represents performance. As can be seen from the figure, through the constellation mapping of probabilistic shaping and the fixed forward error correction, high performance can be achieved while enabling the data to have high rate adaptability.

In addition, types of constellation mapping and forward error correction may be adaptively selected according to rate adaptability and performance requirements.

Referring to Fig. 4, in some embodiments, pre-interleaving the first shaped data to obtain first pre-interleaved data and pre-interleaving the first unshaped data to obtain second pre-interleaved data includes the following steps. At, S301, the first shaped data is pre-interleaved by a pre-interleaver to obtain first pre-interleaved data, and the obtained first pre-interleaved data is stored in a first pre-interleaving area of the pre-interleaver. At S302, the first unshaped data is pre-interleaved by the pre-interleaver to obtain second pre-interleaved data, and the obtained second pre-interleaved data is stored in a second pre-interleaving area of the pre-interleaver.

The first shaped data is pre-interleaved by a pre-interleaver to obtain first pre-interleaved data, and the obtained first pre-interleaved data is stored in a first pre-interleaving area of the pre-interleaver according to a preset interleaving sequence. The first unshaped data is pre-interleaved by the pre-interleaver to obtain second pre-interleaved data, and the obtained second pre-interleaved data is stored in a second pre-interleaving area of the pre-interleaver according to a preset interleaving sequence. The first shaped data and the first unshaped data are respectively and simultaneously pre-interleaved, and the obtained data are stored in corresponding cache areas in the pre-interleaver.

For example, the pre-interleaver has a storage capacity of 32 rows and 111 columns, with a data storage capacity of 3552 bits, where 32 rows and 64 columns on the left, with a data storage capacity of 2048 bits, are configured to store the first pre-interleaved data; and 32 rows and 47 columns on the right, with a data storage capacity of 1504 bits, are configured to store the second pre-interleaved data.

A storage area of the pre-interleaver is regionally divided for filling of the first shaped data and the first unshaped data into corresponding storage areas according to a preset rule, so as to complete the pre-interleaving of the corresponding first shaped data and first unshaped data.

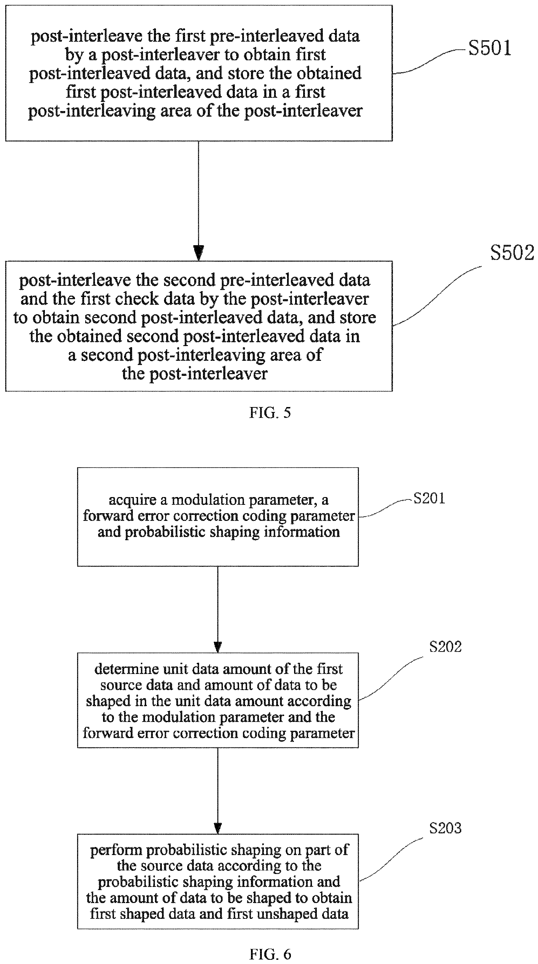

Referring to Fig. 5, in some embodiments, at S500, the first pre-interleaved data is post-interleaved to obtain first post-interleaved data, and the second pre-interleaved data and the first check data are post-interleaved to obtain second post-interleaved data. This process includes the following steps. At, S501, the first pre-interleaved data is post-interleaved by a post-interleaver to obtain first post-interleaved data, and the obtained first post-interleaved data is stored in a first post-interleaving area of the post-interleaver. At, S502, the second pre-interleaved data and the first check data by the post-interleaver are post-interleaved to obtain second post-interleaved data, and the obtained second post-interleaved data are stored in a second post-interleaving area of the post-interleaver.

The corresponding pre-interleaved data is post-interleaved by a post-interleaver to obtain corresponding post-interleaved data, and the corresponding post-interleaved data is stored in a corresponding storage area of the post-interleaver, thus avoiding data confusion in the post-interleaved data. For example, the first pre-interleaved data is post-interleaved according to a preset rule to obtain first post-interleaved data, and the obtained first post-interleaved data is stored in a first post-interleaving area; and the second pre-interleaved data and the first check data are post-interleaved according to a preset rule to obtain second post-interleaved data, and the obtained second post-interleaved data is stored in a second post-interleaving area. It can be understood that the corresponding data is segmented to obtain data blocks, and the obtained data blocks are filled into corresponding storage areas of the post-interleaver according to preset rules, so as to complete the post-interleaving.

The second post-interleaving area is regionally divided to form at least two sub-areas. One sub-area is configured to store the post-interleaved data obtained by post-interleaving the first unshaped data, and the other sub-area is configured to store the post-interleaved data obtained by post-interleaving the first check data.

For example, forward error correction coding is performed on the first pre-interleaved data and the second pre-interleaved data to obtain first check data.

The first pre-interleaved data and the second pre-interleaved data totally have a data size of 3552 bits, while the generated first check data has a data size of 544 bits. The first pre-interleaved data, the second pre-interleaved data and the first check data has a total data size of 4096 (=3552+544) bits.

For example, the post-interleaver has a storage capacity of 32 rows and 128 columns, with a data storage capacity of 4096 bits, where 32 rows and 64 columns on the left, with a data storage capacity of 2048 bits, are configured to store the first pre-interleaved data; 32 rows and 47 columns in the middle, with a data storage capacity of 1504 bits, are configured to store the second pre-interleaved data obtained by post-interleaving the first unshaped data; and 32 rows and 17 columns on the right, with a data storage capacity of 544 bits, are configured to store the second pre-interleaved data obtained by post-interleaving the first check data.

In some embodiments, post-interleaving the first pre-interleaved data to obtain first post-interleaved data and post-interleaving the second pre-interleaved data and the first check data to obtain second post-interleaved data includes: dividing the first pre-interleaved data into a plurality of data blocks according to a preset division rule, and post-interleaving the plurality of data blocks to obtain first post-interleaved data; and dividing the second pre-interleaved data and the first check data into a plurality of data blocks according to a preset division rule, and post-interleaving the plurality of data blocks to obtain second post-interleaved data.

The first pre-interleaved data, the second pre-interleaved data and the first check data are divided into a plurality of data blocks according to preset division rules, and the obtained data blocks are filled into the first post-interleaving area and the second post-interleaving area of the post-interleaver according to preset filling rules or interleaving rules to obtain corresponding first post-interleaved data and second post-interleaved data.

For example, the post-interleaver has a storage capacity of 32 rows and 128 columns, with a data storage capacity of 4096 bits. The first pre-interleaved data, the second pre-interleaved data, and the first check data are divided into data blocks in units of 16*16 small squares according to preset division rules, and corresponding data blocks are interleaved to obtain first post-interleaved data and second post-interleaved data.

The first post-interleaved data and the second post-interleaved data are modulated by a symbol modulator to obtain modulated symbol data.

In some embodiments, a plurality of groups of first post-interleaved data and a plurality of groups of second post-interleaved data are hybridly interleaved respectively to obtain data to be modulated, and the symbol modulator modulates the data to be modulated to obtain modulated symbol data.

For example, the post-interleaver outputs 21 groups of first post-interleaved data and 21 corresponding groups of second post-interleaved data in total. The first post-interleaved data and the second post-interleaved data are interleaved by a hybrid interleaver with a data storage capacity of 672 rows and 128 columns to form corresponding data to be modulated, where 64 columns on the left are configured to store corresponding interleaved data subjected to probabilistic shaping, and 64 columns on the right are configured to store corresponding interleaved data not subjected to probabilistic shaping.

Referring to Fig. 6, in some embodiments, at S200, probabilistic shaping is performed on part of the first source data to obtain first shaped data and first unshaped data. This process includes the following steps. At, S201, a modulation parameter, a forward error correction coding parameter and probabilistic shaping information are acquired. At S202, unit data amount of the first source data and amount of data to be shaped in the unit data amount are determined according to the modulation parameter and the forward error correction coding parameter. At S203, probabilistic shaping is performed on part of the source data according to the probabilistic shaping information and the amount of data to be shaped to obtain first shaped data and first unshaped data.

According to preset processing parameters of the data, the amount of data that needs probabilistic shaping in the source data is pre-divided to determine the unit data amount in the first source data and the amount of data to be shaped in the unit data amount. A shaping type or shaping mode of probabilistic shaping is determined through the probabilistic shaping information, and probabilistic shaping is performed on part of the source data by a probabilistic shaper according to the probabilistic shaping information and the amount of data to be shaped to obtain the first shaped data and the first unshaped data.

The modulation parameter can be used to determine a specific modulation mode of data, and the forward error correction coding parameter can be used to determine the amount of check data generated. According to the amount of data modulated by means of the specific data modulation mode and the amount of check data, the unit data amount of the first source data and the amount of data to be shaped in the unit data amount are determined.

In some embodiments, at S600, the first post-interleaved data and the second post-interleaved data is modulated to obtain modulated symbol data. This process includes: modulating the first post-interleaved data and the second post-interleaved data according to a preset symbol mapping rule to obtain modulated symbol data, where the preset symbol mapping rule includes that: the first post-interleaved data corresponds to amplitude bits of the modulated symbol data, and the second post-interleaved data corresponds to symbol bits of the modulated symbol data.

The data corresponding to the symbol bits and the amplitude bits are respectively post-interleaved to ensure that different data portions in the post-interleaved data are independent of each other and no data crosstalk occurs. The check data is incorporated into the second post-interleaved data to add error correction codes to the symbol bits of the modulated symbol data. Error correction codes are added to the data to be mapped to break up burst error codes introduced by a communication transmission channel, thereby improving the decoding capability of the communication system.

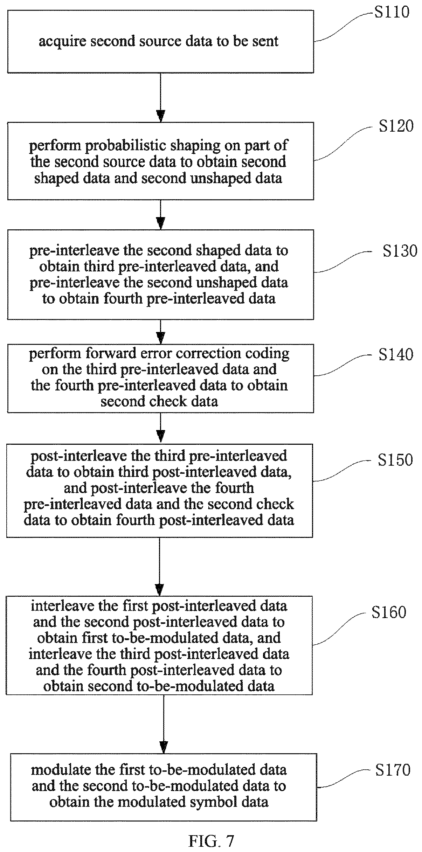

Referring to Fig. 7, in some embodiments, the communication system has second source data in addition to the first source data. The data sending method further includes following steps. At S110, second source data to be sent is acquired. At S 120, probabilistic shaping is performed on part of the second source data to obtain second shaped data and second unshaped data. At S130, the second shaped data is pre-interleaved to obtain third pre-interleaved data, and the second unshaped data is pre-interleaved to obtain fourth pre-interleaved data. At S140, forward error correction coding is performed on the third pre-interleaved data and the fourth pre-interleaved data to obtain second check data. At S150, the third pre-interleaved data is post-interleaved to obtain third post-interleaved data, and the fourth pre-interleaved data and the second check data are post-interleaved to obtain fourth post-interleaved data. At S160, the first post-interleaved data and the second post-interleaved data are interleaved to obtain first to-be-modulated data, and the third post-interleaved data and the fourth post-interleaved data are interleaved to obtain second to-be-modulated data. At S170, the first to-be-modulated data and the second to-be-modulated data are modulated to obtain modulated symbol data.

The second source data to be sent is acquired from a second source data module. Probabilistic shaping is performed on part of the second source data by a second shaper to obtain second shaped data and second unshaped data. The second shaped data is pre-interleaved by a second pre-interleaver to obtain third pre-interleaved data, and the second unshaped data is pre-interleaved by the second pre-interleaver to obtain fourth pre-interleaved data. Forward error correction coding is performed on the third pre-interleaved and the fourth pre-interleaved data by a second forward error correction encoder to obtain second check data. The third pre-interleaved data is post-interleaved by a second post-interleaver to obtain third post-interleaved data, and the fourth pre-interleaved data and the second check data are post-interleaved by the second post-interleaver to obtain fourth post-interleaved data. The first post-interleaved data and the third post-interleaved data are interleaved by a hybrid interleaver to obtain first to-be-modulated data, and the second post-interleaved data and the fourth post-interleaved data are interleaved by the hybrid interleaver to obtain second to-be-modulated data. The first to-be-modulated data and the second to-be-modulated data are modulated by a symbol modulator to obtain modulated symbol data.

The two source data are hybridly interleaved to multiplex a single data transmission channel, thereby simultaneously transmitting two channels of source data.

For example, the first post-interleaver outputs 21 groups of first post-interleaved data and 21 corresponding groups of second post-interleaved data in total; and the second post-interleaver outputs 21 groups of third post-interleaved data and 21 corresponding groups of fourth post-interleaved data in total.

The first post-interleaved data and the second post-interleaved data are interleaved by a hybrid interleaver with a data storage capacity of 1344 rows and 128 columns (a total data storage capacity is 172032 bits) to form corresponding data to be modulated, where 64 columns on the left are configured to store the first post-interleaved data and the third post-interleaved data (corresponding interleaved data subjected to probabilistic shaping), and 64 columns on the right are configured to store the second post-interleaved data and the fourth post-interleaved data (corresponding interleaved data not subjected to probabilistic shaping).

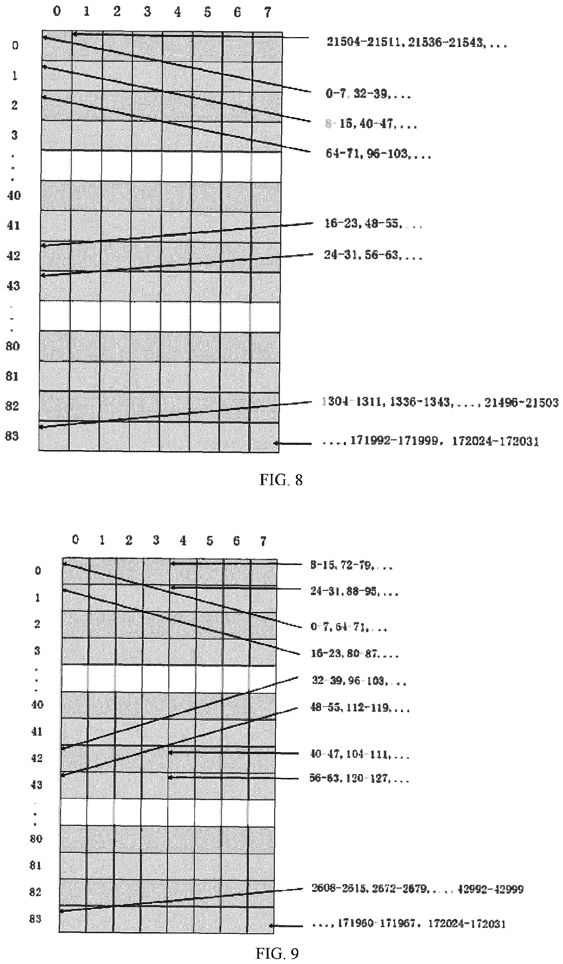

Referring to Fig. 8, Fig. 8 shows a schematic diagram of a hybrid interleaver on the left side, where each small square is a data block with a size of 16* 16; and shows, by digits, an index at the time of data output from an interleaver 3 on the right side. B_{x, y} represents a data block in row x and column y.

A data output sequence of the hybrid interleaver is as follows: bits 0-7 are upper 8 bits of column 0 in B_{0, 0}, bits 8-15 are upper 8 bits of column 0 in B_{1, 0}, bits 16-23 are upper 8 bits of column 0 in B_{42, 0}, bits 24-31 are upper 8 bits of column 0 in B_{43, 0}, bits 32-39 are lower 8 bits of column 0 in B_{0, 0}, bits 40-47 are lower 8 bits of column 0 in B_{1, 0}, bits 48-55 are lower 8 bits of column 0 in B_{42, 0}, bits 56-63 are lower 8 bits of column 0 in B_{43, 0,} and so on.

The symbol modulator maps the 1^{st}, 3^{rd}, 5^{th} and 7^{th} bits of the 8-bit data output by the interleaver each time into one symbol, and the 2^{nd}, 4^{th}, 6^{th} and 8^{th} bits into one symbol.

It can be understood that each data block is in a data array format of 16 rows and 16 columns. In the output process of the hybrid interleaver, if every 8 data bits are taken as one data unit, the data block has 2*8 (2 rows and 16 columns) data units. The hybrid interleaver outputs one data unit to the symbol modulator each time, and the symbol modulator performs constellation mapping on the data in the data units according to preset mapping rules, and maps the data in the data units into corresponding symbols.

Referring to Fig. 9, in some embodiments, an embodiment of the present disclosure further provides a data mapping method for the above data sending method. Fig. 9 shows a schematic diagram of the hybrid interleaver 3 on the left side, where each small square is a data block with a size of 16* 16; and shows, by digits, an index at the time of data output from the interleaver 3 on the right side. B_{x, y} represents a data block in row x and column y.

It can be understood that each data block is in a data array format of 16 rows and 16 columns. In the output process of the hybrid interleaver, if every 8 data bits are taken as on data unit, the data block has 2*8 (2 rows and 16 columns) data units. The hybrid interleaver outputs one data unit to the symbol modulator each time, and the symbol modulator performs constellation mapping on the data in the data units according to preset mapping rules, and maps the data in the data units into corresponding symbols.

Interleaving the first post-interleaved data and the second post-interleaved data to obtain first to-be-modulated data and interleaving the third post-interleaved data and the fourth post-interleaved data to obtain second to-be-modulated data includes: sequentially receiving bit data from the first post-interleaving area and the second post-interleaving area, and sorting the bit data in a preset order to obtain the first to-be-modulated data; and sequentially receiving bit data from the second post-interleaving area and a fourth post-interleaving area, and sorting the bit data according to the preset order to obtain the second to-be-modulated data.

The first post-interleaving area stores the first post-interleaved data (corresponding to amplitude bits of the modulated symbol data) corresponding to the first shaped data. The second post-interleaving area stores the first post-interleaved data (corresponding to symbol bits of the modulated symbol data) corresponding to the first unshaped data. The third interleaving area stores third post-interleaved data (corresponding to amplitude bits of the modulated symbol data) corresponding to the second shaped data. The fourth post-interleaving area stores the fourth post-interleaved data (corresponding to symbol bits of the modulated symbol data) corresponding to the second unshaped data. The data in the first post-interleaving area and the second post-interleaving area are received sequentially to obtain complete first to-be-modulated data. The data in the third post-interleaving area and the fourth post-interleaving area are received sequentially to obtain complete second to-be-modulated data. The first to-be-modulated data includes amplitude bits and symbol bits corresponding to the first source data, and the second to-be-modulated data includes amplitude bits and symbol bits corresponding to the second source data. It can be understood that the first to-be-modulated data and the second to-be-modulated data are mapped into modulated symbol data by 16 QAM mapping.

The data output sequence of the hybrid interleaver is as follows: bits 0-7 are upper 8 bits of column 0 in B_{0, 0}, bits 8-15 are upper 8 bits of column 0 in B_{0, 4}, bits 16-23 are upper 8 bits of column 0 in B_{1, 0}, bits 24-31 are upper 8 bits of column 0 in B_{1, 4}, bits 32-39 are upper 8 bits of column 0 in B_{42, 0}, bits 40-47 are upper 8 bits of column 0 in B_{42, 4}, bits 48-55 are upper 8 bits of column 0 in B_{43, 0}, bits 56-63 are upper 8 bits of column 0 in B_{43, 4}, and so on.

Referring to Fig. 9 together, in some embodiments, modulating the first to-be-modulated data and the second to-be-modulated data to obtain modulated symbol data includes: performing data extraction on the first to-be-modulated data at a preset interval to obtain bit data to be modulated, and performing constellation mapping on the bit data to be modulated to obtain the modulated symbol data; and performing data extraction on the second to-be-modulated data at the preset interval to obtain bit data to be modulated, and performing constellation mapping on the bit data to be modulated to obtain the modulated symbol data.

The symbol modulator takes 32-bit data output by the hybrid interleaver each time as a data cycle, and equivalently extracts data from one data cycle for data modulation. For example, seven bits is taken as an extraction cycle, and one bit every seven bits is taken for constellation mapping. That is, the 0^{th}, 8^{th}, 16^{th} and 24^{th} bits are mapped into one symbol, the 1^{st}, 9^{th}, 17^{th} and 25^{th} bits are mapped into one symbol, and so on. In other embodiments, the preset interval for data extraction may be adaptively adjusted according to the data interleaving mode.

Referring to Fig. 2B together, every 4 data bits are mapped into one symbol, where every 2 data bits are mapped to represent a real part or an imaginary part of one constellation point. That is, half of the bit data to be modulated for 16 QAM mapping is used to represent symbol bits, and the other half is used to represent amplitude bits. The bit data representing amplitude bits comes from the source data subjected to probabilistic shaping, and the bit data representing symbol bits comes from the source data not subjected to probabilistic shaping and the check data generated by forward error correction coding.

According to the data sending method provided in the first aspect of the embodiment of the present disclosure, the shaped data and the unshaped data are interleaved separately to ensure that the data are interleaved and laid out in a preset mode, thereby avoiding the problem that shaping gain cannot be obtained by shaping signals due to data interleaving.

In addition, the first pre-interleaved data and the second pre-interleaved data are subjected to forward error correction coding to obtain first check data, and the second pre-interleaved data and the first check data are post-interleaved to obtain corresponding second post-interleaved data, so as to add the check data to data to be modulated. Therefore, redundant codes with characteristics of signals are added to the sent data, so as to correct data errors caused by data transmission. Because the source data is processed by means of the constellation mapping technology of probabilistic shaping and the fixed forward error correction technology, high performance can be achieved while enabling the data to have high rate adaptability.

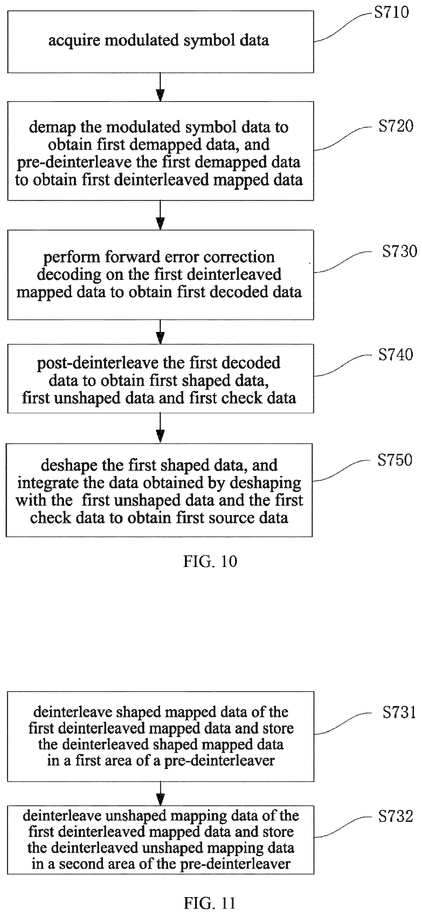

In accordance with a second aspect of the present disclosure, a data receiving method is provided. Referring to Fig. 10, in some embodiments, the data receiving method includes following steps. At S710, modulated symbol data is acquired. At S720, the modulated symbol data is demapped to obtain first demapped data, and the first demapped data is pre-deinterleaved to obtain first deinterleaved mapped data. At S730, forward error correction decoding is performed on the first deinterleaved mapped data to obtain first decoded data. At S740, the first decoded data is post- deinterleaved to obtain first shaped data, first unshaped data and first check data. At S750, the first shaped data is deshaped, and the data obtained by deshaping with the first unshaped data and the first check data are integrated to obtain first source data.

The received modulated symbol data is demapped by a symbol demodulator to obtain demapped data. The first demapped data is pre-deinterleaved by a pre-deinterleaver to obtain first deinterleaved mapped data. The first demapped data is pre-deinterleaved by a forward error correction decoder to obtain first decoded data. The first decoded data is post-deinterleaved by a post-deinterleaver to obtain first shaped data, first unshaped data and first check data. The first shaped data is deshaped by a deshaper. The data obtained by deshaping is integrated with the first unshaped data and the first check data by a data receiver to obtain the first source data.

The data are deinterleaved by the pre-deinterleaver and the post-deinterleaver respectively, and error codes in the first demapped data are corrected by the forward error correction decoder, thereby avoiding the introduction of the error codes into the data caused by the data transmission channel to restore the complete first source data.

Referring to Fig. 11, in some embodiments, at S730, the first demapped data is pre-deinterleaved to obtain first deinterleaved mapped data. This process includes the following steps. At S731, shaped mapped data of the first deinterleaved mapped data is deinterleaved and stored in a first area of the pre-deinterleaver. At S732, unshaped mapping data of the first deinterleaved mapped data is deinterleaved and stored in a second area of the pre-deinterleaver.

A storage area of the pre-deinterleaver is divided into the first area and the second area according to a preset division rule. The first area is configured to store shaped mapped data of the first deinterleaved mapped data; and the second area is configured to store unshaped mapped data of the first deinterleaved mapped data. It can be understood that different parts of the received first demapped data are deinterleaved respectively according to preset interleaving rules, and are stored in corresponding areas of the pre-deinterleaver.

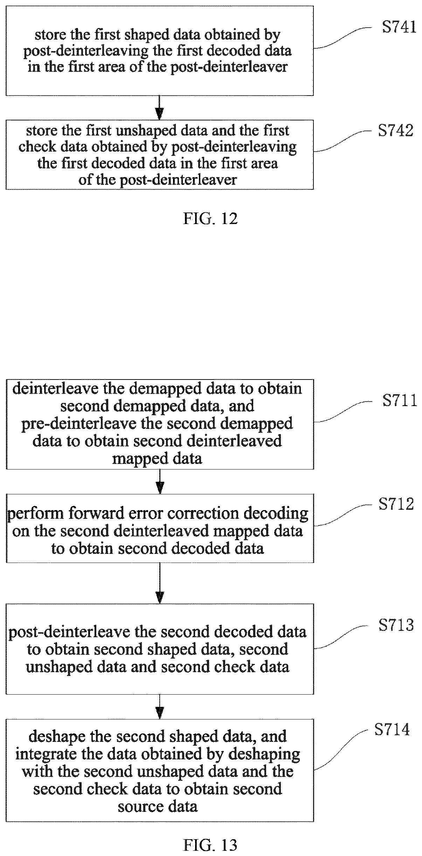

Referring to Fig. 12, in some embodiments, at S740, the first decoded data is post-deinterleaved to obtain first shaped data, first unshaped data and first check data. This process includes the following steps. At S741, the first shaped data obtained by post-deinterleaving the first decoded data is stored in the first area of the post-deinterleaver. At S742, the first unshaped data and the first check data obtained by post-deinterleaving the first decoded data are stored in the first area of the post-deinterleaver.

The first decoded data is post-deinterleaved by the post-deinterleaver, and the obtained first shaped data is stored in the first area of the post-deinterleaver. The first decoded data is post-deinterleaved by the post-deinterleaver, and the obtained first unshaped data and first check data are stored in the first area of the post-deinterleaver.

The processing procedures of S741 and S742 may be processed in parallel or one of S741 and S742 may be selected for priority processing. For example, the first decoded data is post-deinterleaved and stored in the first area of the post-deinterleaver, and after the first shaped data is completely acquired, some data of the first decoded data corresponding to the first unshaped data and the first check data are post-deinterleaved.

Referring to Fig. 13, in some embodiments, the modulated symbol data received by the symbol demodulator is formed by modulating two channels of source data. The data receiving method further includes following steps. At S711, the demapped data is deinterleaved to obtain second demapped data, and the second demapped data is pre-deinterleaved to obtain second deinterleaved mapped data. At S712, forward error correction decoding is performed on the second deinterleaved mapped data to obtain second decoded data. At S713, the second decoded data is post-deinterleaved to obtain second shaped data, second unshaped data and second check data. At S714, the second shaped data is deshaped, and the data obtained by deshaping with the second unshaped data and the second check data is integrated to obtain second source data.

The deinterleaver is configured to deinterleave the demapped data to obtain first demapped data and/or second demapped data. The pre-deinterleaver is configured to pre-deinterleave the second demapped data to obtain second deinterleaved mapped data. The forward error correction decoder is configured to perform forward error correction decoding on the second deinterleaved mapped data to obtain second decoded data. The post-deinterleaver is configured to post-deinterleave the second decoded data to obtain second shaped data, second unshaped data and second check data. The deshaper is configured to deshape the second shaped data. The data receiver is configured to integrate the data obtained by deshaping with the second unshaped data and the second check data to obtain second source data. The demapped data is deinterleaved by the deinterleaver to obtain first demapped data corresponding to the first source data and second demapped data corresponding to the second source data.

Subsequent processing steps are performed on the first demapped data and the second demapped data respectively to obtain complete first source data and second source data.

According to the data receiving method provided by the embodiment of the second aspect of the present disclosure, the data are deinterleaved by the pre-deinterleaver and the post-deinterleaver respectively, and error codes in the first demapped data are corrected by the forward error correction decoder to avoid the introduction of the error codes into the data caused by the data transmission channel, thereby restoring the complete first source data.

When the modulated symbol data received by the symbol demodulator is formed by modulating by two channels of source data, the demapped data is deinterleaved by the deinterleaver to obtain first demapped data and/or second demapped data, and the first source data and/or the second source data are/is obtained respectively based on the first demapped data and/or the second demapped data, so as to efficiently and quickly process the received data.

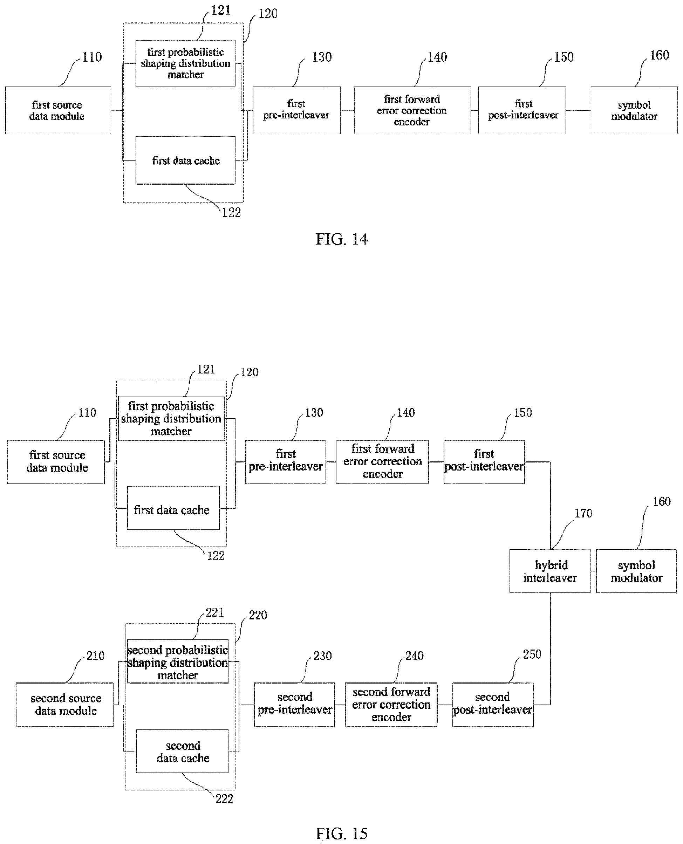

In accordance with a third aspect of the present disclosure, a data sending terminal is provided. Referring to Fig. 14, in some embodiments, the data sending terminal includes: a first source data module 110, configured to generate first source data; a first probabilistic shaper 120, communicatively connected with the first source data module 110, and configured to perform probabilistic shaping on part of the first source data to obtain first shaped data and first unshaped data; a first pre-interleaver 130, communicatively connected with the first probabilistic shaper 120, and configured to pre-interleave the first shaped data to obtain first pre-interleaved data and pre-interleave the first unshaped data to obtain second pre-interleaved data; a first forward error correction encoder 140, communicatively connected with the first pre-interleaver 130, and configured to perform forward error correction coding on the first pre-interleaved data and the second pre-interleaved data to obtain first check data; a first post-interleaver 150, communicatively connected with the first forward error correction encoder 140, and configured to post-interleave the first pre-interleaved data to obtain first post-interleaved data and post-interleave the second pre-interleaved data and the first check data to obtain second post-interleaved data; and a symbol modulator 160, configured to modulate the first post-interleaved data and the second post-interleaved data to obtain modulated symbol data.

The first shaped data and the first unshaped data are respectively pre-interleaved by the first pre-interleaver 130 to generate corresponding first pre-interleaved data and second pre-interleaved data, thereby preventing data subjected to probabilistic shaping from interleaving with data not subjected to probabilistic shaping with each other to cause data interleaving confusion, which makes it impossible to modulate and map the corresponding interleaved data correctly. The shaped data and the unshaped data are interleaved separately by the first pre-interleaver 130 to ensure that the data are interleaved and laid out in a preset mode, thereby avoiding the problem that shaping gain cannot be obtained by shaping signals due to data interleaving.

The first pre-interleaved data, the second pre-interleaved data and the first check data are interleaved separately by the first post-interleaver 150, thereby avoiding the problem that shaping gain cannot be obtained by shaping the source data or the shaping gain effect is not good because the shaped data and the unshaped data are interleavered with each other in the interleaving process.

In some embodiments, the first pre-interleaver 130 includes a first pre-interleaving area and a second pre-interleaving area. The first pre-interleaving area is configured to store first pre-interleaved data, and the second pre-interleaving area is configured to store second pre-interleaved data. The first post-interleaver 150 includes a first post-interleaving area and a second post-interleaving area. The first post-interleaving area is configured to store first post-interleaved data, and the second post-interleaving area is configured to store second post-interleaved data.

Referring to Fig. 15, in some embodiments, the data sending terminal includes at least two channels of source data input. The data sending terminal further includes: a second source data module 210, configured to generate second source data; a second probabilistic shaper 220, communicatively connected with the second source data module 210, and configured to perform probabilistic shaping on part of the second source data to obtain second shaped data and second unshaped data; a second pre-interleaver 230, communicatively connected with the second probabilistic shaper 220, and configured to pre-interleave the second shaped data to obtain third pre-interleaved data and pre-interleave the second unshaped data to obtain fourth pre-interleaved data; a second forward error correction encoder 240, communicatively connected with the second pre-interleaver 230, and configured to perform forward error correction coding on the third pre-interleaved data and the fourth pre-interleaved data to obtain second check data; a second post-interleaver 250, communicatively connected with the second forward error correction encoder 240, and configured to post-interleave the third pre-interleaved data to obtain third post-interleaved data and post-interleave the fourth pre-interleaved data and the second check data to obtain fourth post-interleaved data; a hybrid interleaver 170, communicatively connected with the first post-interleaver 150 and the second post-interleaver 250, and configured to interleave the first post-interleaved data and the third post-interleaved data to obtain first to-be-modulated data and interleave the second post-interleaved and the fourth post-interleaved data to obtain second to-be-modulated data, where the first to-be-modulated data is stored in a first hybrid interleaving area of the hybrid interleaver 170, and the second to-be-modulated data is stored in a second hybrid interleaving area of the hybrid interleaver 170. The symbol modulator 160 modulates the first to-be-modulated data and the second to-be-modulated data to obtain modulated symbol data.

The first pre-interleaver 130 and the second pre-interleaver each have a data storage capacity of 3552 bits totally, while the generated first check data has a data size of 544 bits. The first pre-interleaved data, the second pre-interleaved data and the first check data have a total data size of 4096 (=3552+544) bits; and the third pre-interleaved data, the fourth pre-interleaved data and the second check data have a total data size of 4096 (=3552+544) bits.

21 groups of first post-interleaved data, 21 groups of second post-interleaved data, 21 groups of third post-interleaved data and 21 groups of fourth post-interleaved data are hybridly interleaved and stored in the hybrid interleaver 170. The hybrid interleaver 170 has a data storage capacity of 1344 rows and 128 columns (a total data storage capacity of 172032 bits), where 64 columns on the left store the data subjected to probabilistic shaping (the first post-interleaved data and the third post-interleaved data), and 64 columns on the right store the data not subjected to probabilistic shaping (the second post-interleaved data and the fourth post-interleaved data).

In some embodiments, the first pre-interleaver 130 includes a first pre-interleaving area and a second pre-interleaving area. The first pre-interleaving area is configured to store first pre-interleaved data, and the second pre-interleaving area is configured to store second pre-interleaved data. The second pre-interleaver 230 includes a third pre-interleaving area and a fourth pre-interleaving area. The third pre-interleaving area is configured to store third pre-interleaved data, and the fourth pre-interleaving area is configured to store fourth pre-interleaved data.

The first shaped data is pre-interleaved by a pre-interleaver to obtain first pre-interleaved data, and the obtained first pre-interleaved data is stored in the first pre-interleaving area of the pre-interleaver according to a preset interleaving sequence. The first unshaped data is pre-interleaved by the pre-interleaver to obtain second pre-interleaved data, and the obtained second pre-interleaved data is stored in the second pre-interleaving area of the pre-interleaver according to a preset interleaving sequence. The first shaped data and the unshaped data are respectively and simultaneously pre-interleaved, and the obtained data is stored in corresponding cache areas in the pre-interleaver.

In some embodiments, the first probabilistic shaper 120 includes: a first probabilistic shaping distribution matcher 121, configured to shape part of the first source data to obtain first shaped data; and a first data cache 122, communicatively connected with the first source data module 110, and configured to store first unshaped data. The second probabilistic shaper 220 includes: a second probabilistic shaping distribution matcher 221, configured to shape part of the second source data to obtain second shaped data; and a second data cache 222, communicatively connected with the second source data module 210, and configured to store the second unshaped data.

In some embodiments, the first forward error correction encoder 140 and/or the second forward error correction encoder 240 are/is Open Forward Error Correction (OFEC) encoders. According to data transmission environments or data types, different forward error correction encoders may be selected for interleaved data coding. The OFEC encoders may be considered as signal processing devices for performing forwarding error correction technology. OFEC coding includes two stages of error correction, i.e., a first stage of IntroPacket and a second stage of Extrapacket.

Thus, according to the data sending terminal provided in the embodiments of the third aspect of the present disclosure, the source data is interleaved, coded and modulated by a preset data transmission terminal to facilitate a rapid processing of the source data, so that high performance can be achieved while enabling the data to have high rate adaptability.

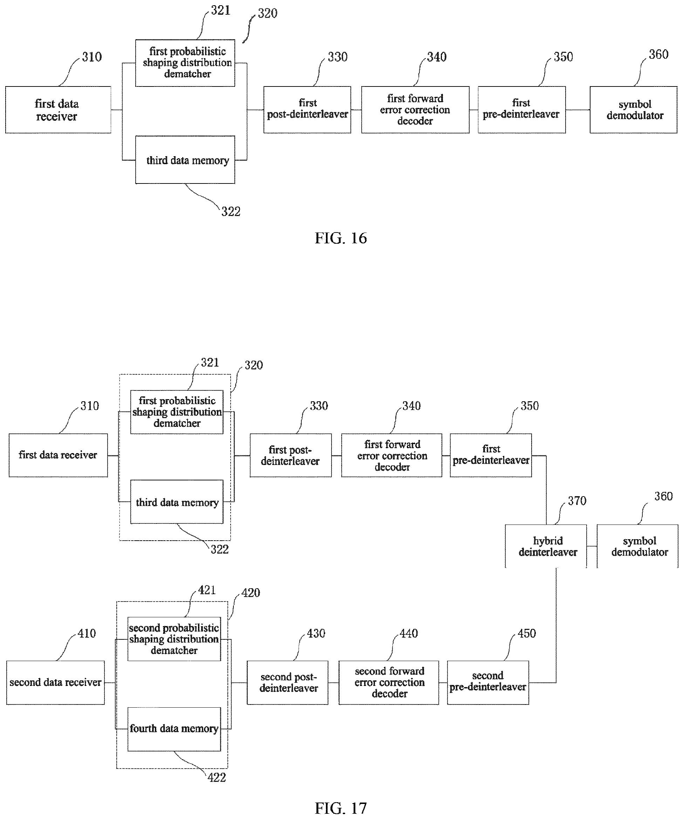

Referring to Fig. 16, in some embodiments, the data receiving terminal includes: a symbol demodulator 360, configured to demap modulated symbol data to obtain first demapped data; a first pre-deinterleaver 350, configured to pre-deinterleave the first demapped data to obtain first deinterleaved mapped data; a first forward error correction decoder 340, configured to perform forward error correction decoding on the first deinterleaved mapped data to obtain first decoded data; a first post-deinterleaver 330, configured to post-deinterleave the first decoded data to obtain first shaped data, first unshaped data and first check data; a first probabilistic deshaper 320, configured to deshape the first shaped data and transmit generated data to a first data receiver 310; and the first data receiver 310, configured to integrate the data from the first probabilistic deshaper 320 with the first unshaped data and the first check data to obtain first source data.

It can be understood that the symbol demodulator 360 receives and demaps first modulated symbol data to obtain first demapped data. The first demapped data is pre-deinterleaved by the first pre-deinterleaver 350 to obtain first deinterleaved mapped data. The first demapped data is pre-deinterleaved by the first forward error correction decoder 340 to obtain first decoded data. The first decoded data is post-deinterleaved by the first post-deinterleaver 330 to obtain first shaped data, first unshaped data and first check data. The first shaped data is deshaped by the deshaper, and the data obtained by deshaping is integrated with the first unshaped data and the first check data by the data receiver to obtain first source data.

The data to be deinterleaved is deinterleaved by the first pre-deinterleaver 350 and the first post-deinterleaver 330 respectively, and error codes in the first demapped data are corrected by the forward error correction decoder to avoid the introduction of the error codes into the data caused by the data transmission channel, in order to restore the complete first source data.

Referring to Fig. 17, in some embodiments, the modulated symbol data received by the symbol demodulator 360 is obtained by modulating two channels of source data. The data receiving terminal includes: a hybrid deinterleaver 370 configured to deinterleave the demapped data to obtain first demapped data and second demapped data.

The demapped data is deinterleaved by the hybrid deinterleaver 370 to obtain the first demapped data and the second demapped data respectively, and both the first demapped data and the second demapped data are sent to corresponding data processing links.

In some embodiments, the data receiving terminal includes: a second pre-deinterleaver 450, configured to pre-deinterleave the second demapped data to obtain second deinterleaved mapped data; a second forward error correction decoder 440, configured to perform forward error correction decoding on the second deinterleaved mapped data to obtain second decoded data; a second post-deinterleaver 430, configured to post-deinterleave the second decoded data to obtain second shaped data, second unshaped data and second check data; a second probabilistic deshaper 420, configured to deshape the second shaped data and transmit generated data to a second data receiver 410; and the second data receiver 410, configured to integrate the data from the second probabilistic deshaper 420 with the second unshaped data and the second check data to obtain second source data.

The hybrid deinterleaver 370 is configured to deinterleave the demapped data to obtain first demapped data and/or second demapped data. The pre-deinterleaver is configured to pre-deinterleave the second demapped data to obtain second deinterleaved mapped data. The forward error correction decoder is configured to perform forward error correction decoding on the second deinterleaved mapped data to obtain second decoded data. The post-deinterleaver is configured to post-deinterleave the second decoded data to obtain second shaped data, second unshaped data and second check data. The deshaper is configured to deshape the second shaped data. The data receiver is configured to integrate the data obtained by deshaping with the second unshaped data and the second check data to obtain second source data. The demapped data is deinterleaved by the deinterleavers to obtain first demapped data corresponding to the first source data and second demapped data corresponding to the second source data.

Referring to Fig. 17, in some embodiments, the first probabilistic deshaper 320 includes: a first probabilistic shaping distribution dematcher 321, configured to deshape the first shaped data; and a third data memory 322, configured to store the first unshaped data and the first check data. The second probabilistic deshaper 420 includes: a second probabilistic shaping distribution dematcher 421, configured to deshape the second shaped data; and a fourth data memory 422, configured to store the second unshaped data and the second check data.

In some embodiments, the first forward error correction decoder 340 and/or the second forward error correction decoder 440 are/is OFEC decoders. According to forward error correction coding types, different forward error correction encoders may be selected to code interleaved data.

Thus, according to the data receiving terminal provided in the embodiments of the fourth aspect of the present disclosure, the received modulated symbol data is deinterleaved and decoded through a preset data receiving architecture to restore the modulated symbol data received from the channel and obtain the source data.

In accordance with a fifth aspect of the present disclosure, a data communication system is provided. In some embodiments, the data communication system includes the data sending terminal in any one of the above embodiments and/or the data receiving terminal in any one of the above embodiments.

A complete data system is formed by the data sending terminal as discussed above, the data receiving terminal as discussed above and data transmission channels arranged between the data sending terminal and the data receiving terminal. The system combines probabilistic shaping with forward error correction coding/decoding to optimize the transmission performance of the optical transmission system. By presetting the transmission of the system, a net information rate of the system can be flexibly adjusted, an Optical Signal to Noise Ratio (OSNR) tolerance of the system can be increased, and a signal transmission distance can be increased.

In accordance with a sixth aspect of the present disclosure, an electronic device is provided. In some embodiments, the electronic device includes: a memory storing a computer program; a processor configured to execute the computer program in the memory to implement the steps of the data sending method in any one of the above embodiments; and/or the steps of the data receiving method in any one of the above embodiments.

In accordance with a seventh aspect of the present disclosure, a computer-readable storage medium is provided. In some embodiments, the computer-readable storage medium stores a computer-executable instruction which, when executed by a processor, causes the processor to implement:
the data sending method of any one of the above embodiments,
   and/or
the data receiving method of any one of the above embodiments.

In accordance with an eighth aspect of the present disclosure, a data communication method is provided. In some embodiments, the data communication method includes the data sending method of any one of the embodiments; and/or the data receiving method in any one of the embodiments.

In the embodiment of the present disclosure, by means of the data processing method in the embodiments of the present disclosure, signals are laid out in a preset mode in the process of signal interleaving, thereby ensuring that shaping gain can be obtained by shaping the signals, and the transmission performance of the optical communication system can be optimized and improved.

The device embodiments described above are merely illustrative, and the units described as separate components may or may not be physically separated, that is, may be located in one place, or may be distributed onto multiple network elements. Some or all of the modules may be selected according to actual needs to achieve the purpose of this embodiment.

As will be understood by those having ordinary skills in the art that all or some of the steps, and systems in the method disclosed above may be implemented as software, firmware, hardware and appropriate combinations thereof. Some or all of the physical components may be implemented as software executed by a processor, such as a central processing unit, a digital signal processor or a microprocessor, or as hardware, or as an integrated circuit, such as an application specific integrated circuit. Such software may be distributed on a computer-readable medium, and the computer-readable medium may include a computer storage medium (or a non-transitory medium) and a communication medium (or a transitory medium). As is well known to those having ordinary skills in the art, the term "computer storage medium" includes volatile and nonvolatile, removable and non-removable media implemented in any method or technology for storing information such as computer readable instructions, data structures, program modules or other data. A computer storage medium may include RAM, ROM, EEPROM, flash memory or other memory technologies, CD-ROM, digital versatile disk (DVD) or other optical disk storage, magnetic cassette, magnetic tape, magnetic disk storage or other magnetic storage devices, or any other media that can be used to store desired information and can be accessed by a computer. In addition, it is well known to those having ordinary skills in the art that the communication medium may generally include computer readable instructions, data structures, program modules or other data in a modulated data signal such as a carrier wave or other transmission mechanism, and may include any information delivery medium.

The above is a detailed description of some embodiments of the present disclosure, but the present disclosure is not limited to the above embodiments. Those having ordinary skills in the art can also make various equivalent modifications or substitutions without violating the scope of the present disclosure, and these equivalent modifications or substitutions are all included in the scope defined by the claims of the present disclosure.

## Claims

1. A data sending method, comprising:
acquiring first source data to be sent;
performing probabilistic shaping on part of the first source data to obtain first shaped data and first unshaped data;
pre-interleaving the first shaped data to obtain first pre-interleaved data, and pre-interleaving the first unshaped data to obtain second pre-interleaved data;
performing forward error correction coding on the first pre-interleaved data and the second pre-interleaved data to obtain first check data;
post-interleaving the first pre-interleaved data to obtain first post-interleaved data, and post-interleaving the second pre-interleaved data and the first check data to obtain second post-interleaved data; and
modulating the first post-interleaved data and the second post-interleaved data to obtain modulated symbol data.

2. The data sending method of claim 1, wherein pre-interleaving the first shaped data to obtain first pre-interleaved data and pre-interleaving the first unshaped data to obtain second pre-interleaved data comprises:
pre-interleaving the first shaped data by a pre-interleaver to obtain the first pre-interleaved data, and storing the obtained first pre-interleaved data in a first pre-interleaving area of the pre-interleaver; and
pre-interleaving the first unshaped data by the pre-interleaver to obtain the second pre-interleaved data, and storing the obtained second pre-interleaved data in a second pre-interleaving area of the pre-interleaver.

3. The data sending method of claim 1, wherein post-interleaving the first pre-interleaved data to obtain first post-interleaved data and post-interleaving the second pre-interleaved data and the first check data to obtain second post-interleaved data comprises:
post-interleaving the first pre-interleaved data by a post-interleaver to obtain the first post-interleaved data, and storing the obtained first post-interleaved data in a first post-interleaving area of the post-interleaver; and
post-interleaving the second pre-interleaved data and the first check data by the post-interleaver to obtain the second post-interleaved data, and storing the obtained second post-interleaved data in a second post-interleaving area of the post-interleaver.

4. The data sending method of claim 1, wherein post-interleaving the first pre-interleaved data to obtain first post-interleaved data and post-interleaving the second pre-interleaved data and the first check data to obtain second post-interleaved data comprises:
dividing the first pre-interleaved data into a plurality of data blocks according to a preset division rule, and post-interleaving the plurality of data blocks to obtain the first post-interleaved data; and
dividing the second pre-interleaved data and the first check data into a plurality of data blocks according to a preset division rule, and post-interleaving the plurality of data blocks to obtain the second post-interleaved data.

5. The data sending method of any one of claims 1 to 4, wherein performing probabilistic shaping on part of the first source data to obtain first shaped data and first unshaped data comprises:
acquiring a modulation parameter, a forward error correction coding parameter and probabilistic shaping information;
determining unit data amount of the first source data and amount of data to be shaped in the unit data amount according to the modulation parameter and the forward error correction coding parameter; and
performing probabilistic shaping on part of the source data according to the probabilistic shaping information and the amount of data to be shaped to obtain the first shaped data and the first unshaped data.

6. The data sending method of claim 5, wherein modulating the first post-interleaved data and the second post-interleaved data to obtain modulated symbol data comprises:
modulating the first post-interleaved data and the second post-interleaved data according to a preset symbol mapping rule to obtain the modulated symbol data,
wherein the preset symbol mapping rule comprises that: the first post-interleaved data corresponds to amplitude bits of the modulated symbol data, and the second post-interleaved data corresponds to symbol bits of the modulated symbol data.

7. The data sending method of claim 1, further comprising:
acquiring second source data to be sent;
performing probabilistic shaping on part of the second source data to obtain second shaped data and second unshaped data;
pre-interleaving the second shaped data to obtain third pre-interleaved data, and pre-interleaving the second unshaped data to obtain fourth pre-interleaved data;
performing forward error correction coding on the third pre-interleaved data and the fourth pre-interleaved data to obtain second check data;
post-interleaving the third pre-interleaved data to obtain third post-interleaved data, and post-interleaving the fourth pre-interleaved data and the second check data to obtain fourth post-interleaved data;
interleaving the first post-interleaved data and the second post-interleaved data to obtain first to-be-modulated data, and interleaving the third post-interleaved data and the fourth post-interleaved data to obtain second to-be-modulated data; and
modulating the first to-be-modulated data and the second to-be-modulated data to obtain the modulated symbol data.

8. The data sending method of claim 7, wherein interleaving the first post-interleaved data and the second post-interleaved data to obtain first to-be-modulated data comprises:
sequentially receiving bit data from the first post-interleaving area and the second post-interleaving area, and sorting the bit data in a preset order to obtain the first to-be-modulated data; and
wherein modulating the first to-be-modulated data and the second to-be-modulated data to obtain the modulated symbol data comprises:
performing data extraction on the first to-be-modulated data according to a preset interval to obtain bit data to be modulated, and performing constellation mapping on the bit data to be modulated to obtain the modulated symbol data.

9. A data receiving method, comprising:
acquiring modulated symbol data;
demapping the modulated symbol data to obtain first demapped data, and pre-deinterleaving the first demapped data to obtain first deinterleaved mapped data;
performing forward error correction decoding on the first deinterleaved mapped data to obtain first decoded data;
post-deinterleaving the first decoded data to obtain first shaped data, first unshaped data and first check data; and
deshaping the first shaped data, and integrating data obtained by deshaping with the first unshaped data and the first check data to obtain first source data.

10. The data receiving method of claim 9, wherein pre-deinterleaving the first demapped data to obtain first deinterleaved mapped data comprises:
deinterleaving shaped mapped data of the first deinterleaved mapped data and storing the deinterleaved shaped mapped data in a first area of a pre-deinterleaver; and
deinterleaving unshaped mapped data of the first deinterleaved mapped data and storing the deinterleaved unshaped mapped data in a second area of the pre-deinterleaver; and
wherein post-deinterleaving the first decoded data to obtain first shaped data, first unshaped data and first check data comprises:
storing the first shaped data obtained by post-deinterleaving the first decoded data in a first area of a post-deinterleaver; and
storing the first unshaped data and the first check data obtained by post-deinterleaving the first decoded data in the first area of the post-deinterleaver.

11. The data receiving method of claim 9, further comprising:
deinterleaving the demapped data to obtain second demapped data;
pre-deinterleaving the second demapped data to obtain second deinterleaved mapped data;
performing forward error correction decoding on the second deinterleaved mapped data to obtain second decoded data;
post-deinterleaving the second decoded data to obtain second shaped data, second unshaped data and second check data; and
deshaping the second shaped data, and integrating data obtained by deshaping with the second unshaped data and the second check data to obtain second source data.

12. A data sending terminal, comprising:
a first source data module, configured to generate first source data;
a first probabilistic shaper, communicatively connected with the first source data module, and configured to perform probabilistic shaping on part of the first source data to obtain first shaped data and first unshaped data;
a first pre-interleaver, communicatively connected with the first probabilistic shaper, and configured to pre-interleave the first shaped data to obtain first pre-interleaved data, and pre-interleave the first unshaped data to obtain second pre-interleaved data;
a first forward error correction encoder, communicatively connected with the first pre-interleaver, and configured to perform forward error correction coding on the first pre-interleaved data and the second pre-interleaved data to obtain first check data;
a first post-interleaver, communicatively connected with the first forward error correction encoder, and configured to post-interleave the first pre-interleaved data to obtain first post-interleaved data, and post-interleave the second pre-interleaved data and the first check data to obtain second post-interleaved data; and
a symbol modulator, configured to modulate the first post-interleaved data and the second post-interleaved data to obtain modulated symbol data.

13. The data sending terminal of claim 12, wherein the first pre-interleaver comprises a first pre-interleaving area and a second pre-interleaving area;
the first pre-interleaving area is configured to store the first pre-interleaved data, and the second pre-interleaving area is configured to store the second pre-interleaved data; and
wherein the first post-interleaver comprises a first post-interleaving area and a second post-interleaving area;
the first post-interleaving area is configured to store the first post-interleaved data, and the second post-interleaving area is configured to store the second post-interleaved data.

14. The data sending terminal of claim 13, further comprising:
a second source data module, configured to generate second source data;
a second probabilistic shaper, communicatively connected with the second source data module, and configured to perform probabilistic shaping on part of the second source data to obtain second shaped data and second unshaped data;
a second pre-interleaver, communicatively connected with the second probabilistic shaper, and configured to pre-interleave the second shaped data to obtain third pre-interleaved data and pre-interleave the second unshaped data to obtain fourth pre-interleaved data;
a second forward error correction encoder, communicatively connected with the second pre-interleaver, and configured to perform forward error correction coding on the third pre-interleaved data and the fourth pre-interleaved data to obtain second check data;
a second post-interleaver, communicatively connected with the second forward error correction encoder, and configured to post-interleave the third pre-interleaved data to obtain third post-interleaved data and post-interleave the fourth pre-interleaved data and the second check data to obtain fourth post-interleaved data; and
a hybrid interleaver, communicatively connected with the first post-interleaver and the second post-interleaver, and configured to interleave the first post-interleaved data and the third post-interleaved data to obtain first to-be-modulated data, and interleave the second post-interleaved data and the fourth post-interleaved data to obtain second to-be-modulated data, the first to-be-modulated data being stored in a first hybrid interleaving area of the hybrid interleaver, and the second to-be-modulated data being stored in a second hybrid interleaving area of the hybrid interleaver;
wherein the symbol modulator is configured to modulate the first to-be-modulated data and the second to-be-modulated data to obtain the modulated symbol data.

15. The data sending terminal of claim 13, wherein the first pre-interleaver comprises a first pre-interleaving area and a second pre-interleaving area;
the first pre-interleaving area is configured to store the first pre-interleaved data, and the second pre-interleaving area is configured to store the second pre-interleaved data; and
wherein the second pre-interleaver comprises a third pre-interleaving area and a fourth pre-interleaving area;
the third pre-interleaving area is configured to store the third pre-interleaved data, and the fourth pre-interleaving area is configured to store the fourth pre-interleaved data.

16. The data sending terminal of claim 14, wherein the first probabilistic shaper comprises:
a first probabilistic shaping distribution matcher, configured to shape part of the first source data to obtain the first shaped data; and
a first data cache, communicatively connected with the first source data module, and configured to store the first unshaped data; and
wherein the second probabilistic shaper comprises:
a second probabilistic shaping distribution matcher, configured to shape part of the second source data to obtain the second shaped data; and
a second data cache, communicatively connected with the second source data module, and configured to store the second unshaped data.

17. A data receiving terminal, comprising:
a symbol demodulator, configured to demap modulated symbol data to obtain first demapped data;
a first pre-deinterleaver, configured to pre-deinterleave the first demapped data to obtain first deinterleaved mapped data;
a first forward error correction decoder, configured to perform forward error correction decoding on the first deinterleaved mapped data to obtain first decoded data;
a first post-deinterleaver, configured to post-deinterleave the first decoded data to obtain first shaped data, first unshaped data and first check data;
a first probabilistic deshaper, configured to deshape the first shaped data and transmit generated data to a first data receiver; and
the first data receiver, configured to integrate the data from the first probabilistic deshaper with the first unshaped data and the first check data to obtain first source data.

18. The data receiving terminal of claim 17, further comprising:
a deinterleaver, configured to deinterleave the demapped data to obtain first demapped data and second demapped data;
a second pre-deinterleaver, configured to pre-deinterleave the second demapped data to obtain second deinterleaved mapped data;
a second forward error correction decoder, configured to perform forward error correction decoding on the second deinterleaved mapped data to obtain second decoded data;
a second post-deinterleaver, configured to post-deinterleave the second decoded data to obtain second shaped data, second unshaped data and second check data;
a second probabilistic deshaper, configured to deshape the second shaped data and transmit generated data to a second data receiver; and
the second data receiver, configured to integrate the data from the second probabilistic deshaper with the second unshaped data and the second check data to obtain second source data.

19. A data communication system, comprising the data sending terminal of any one of claims 12 to16 and/or the data receiving terminal of any one of claims 17 to 18.

20. An electronic device, comprising: a memory storing a computer program and a processor configured to execute the computer program in the memory to perform:
the data sending method of any one of claims 1 to 8;
and/or
the data receiving method of any one of claims 9 to 11.

21. A computer-readable storage medium storing a computer-executable instruction which, when executed by a processor, causes the processor to perform:
the data sending method of any one of claims 1 to 8;
and/or
the data receiving method of any one of claims 9 to 11.
